# FASCICULE DE BREVET EUROPEEN

(11) **EP 2 365 518 B1**
(45) Date de publication et mention de la délivrance du brevet: **14.11.2018**
(21) Numéro de dépôt: 11157319.2
(22) Date de dépôt: 08.03.2011
(51) Int. Cl.: H01L 21/762

(54) **Procédé de fabrication d'un substrat comprenant une étape d'amincissement avec arrêt à détection d'une zone poreuse**
Verfahren zur Herstellung eines Substrats, welches einen Verfahrensschritt zum Dünnen mit Stop auf einer porösen Schicht beinhaltet
Method for manufacturing a substrate comprising a thinning step which stops when a porous area is detected

(30) Priorité: 10.03.2010 FR 1051714
(43) Date de publication de la demande: 14.09.2011
(73) Titulaire: COMMISSARIAT À L'ÉNERGIE ATOMIQUE ET AUX ÉNERGIES ALTERNATIVES, 75015 Paris (FR)
(72) Inventeur: Gaillard, Frédéric-Xavier, 38500, Voiron (FR); Nemouchi, Fabrice, 38430, Moirans (FR)
(74) Mandataire: Decobert, Jean-Pascal

(56) Documents cités:
- DE-A1- 10 100 194
- US-A- 6 054 363
- US-B1- 6 301 006
- YONEHARA T ET AL: "EPITAXIAL LAYER TRANSFER BY BOND AND ETCH BACK OF POROUS SI", APPLIED PHYSICS LETTERS, AIP, AMERICAN INSTITUTE OF PHYSICS, MELVILLE, NY, US LNKD- DOI:10.1063/1.111698, vol. 64, no. 16, 18 avril 1994 (1994-04-18), pages 2108-2110, XP000440703, ISSN: 0003-6951
- MASZARA ET AL: "Wafer bonding: SOI, generalized bonding, and new structures", MICROELECTRONIC ENGINEERING, ELSEVIER PUBLISHERS BV., AMSTERDAM, NL LNKD- DOI:10.1016/0167-9317(93)90178-8, vol. 22, no. 1-4, 1 août 1993 (1993-08-01) , pages 299-306, XP024436855, ISSN: 0167-9317 [extrait le 1993-08-01]

## Description

### DOMAINE TECHNIQUE DE L'INVENTION

La présente invention concerne la technologie des circuits intégrés en général et décrit plus particulièrement un procédé permettant un contrôle précis de l'amincissement d'un substrat dans le cadre de la réalisation de dispositifs à partir des deux faces dudit substrat.

### ÉTAT DE LA TECHNIQUE

Si la technologie des circuits intégrés a énormément évoluée depuis leur introduction et leur large déploiement qui a commencé dès le début des années soixante elle est cependant longtemps restée proche, dans son principe, du mode de fabrication initial. Partant d'un substrat, c'est-à-dire d'une tranche très fine tronçonnée dans un lingot fait d'un matériau semi conducteur monocristallin, du silicium essentiellement, toutes les opérations qui permettent la réalisation des circuits intégrés s'effectuent à partir d'une seule des faces du substrat. Face qui a préalablement été soigneusement traitée mécaniquement et/ou chimiquement jusqu'à obtenir un poli de qualité optique. À partir de ce composant de base utilisé par toute l'industrie de la micro électronique, et généralement produit par des fabricants spécialisés, toutes les opérations s'enchaînent pour réaliser, sur la surface polie du substrat, à partir d'une seule des faces donc, les circuits intégrés des plus simples aux plus complexes.

Des techniques telles que : épitaxie, dépôt, gravure, implantation ionique, photolithographie, traitement thermique, polissage mécano chimique, nettoyage/décapage sont couramment utilisées dans la fabrication de composants microélectroniques.

Quoi que les techniques ci-dessus, et en particulier la photo lithographie, aient dû évoluer considérablement au cours des cinq décennies qui ont vu, depuis les années soixante, un accroissement exponentiel jamais démenti de la densité d'intégration des circuits intégrés, la technologie est restée la même en ce que les composants sont toujours formés en surface et à partir d'une seule des faces du substrat.

Ce n'est que beaucoup plus récemment que pour, entre autres besoins, celui de pouvoir disposer de composants hybrides performants, par exemple, des composants optoélectroniques tels que des imageurs du type de ceux qui sont utilisés dans les appareils photos et les caméras numériques, dans lesquels fonctions électroniques et optiques sont intimement imbriquées, il est apparu très avantageux de pouvoir réaliser ces composants à partir des deux faces d'un même substrat. Ce qui élargissait considérablement les possibilités de réalisation tout en permettant une grande amélioration de nombre de leurs caractéristiques opérationnelles. Ainsi dans l'exemple ci-dessus d'un imageur, la réalisation des circuits électroniques et leur interconnexion peuvent se faire classiquement sur une face sans interférer avec la réalisation de micro lentilles sur l'autre face et, donc, sans impacter les paramètres optiques du composant.

Il y a bien d'autres exemples dans lesquels la réalisation de dispositifs à partir des deux faces d'un même substrat est très avantageuse incluant les dispositifs hybrides dits NEMS ou MEMS de l'anglais « nano/micro electro mechanical system ».

Pour pouvoir mettre en oeuvre cette façon de faire, le substrat d'origine, après réalisation de tout ou partie des composants sur l'une des faces, doit être transféré sur un support mécanique, un second substrat, afin de pouvoir amincir le premier, à partir de l'autre face, jusqu'à approcher le plus possible tout en la préservant la zone superficielle dans laquelle les premiers composants ont été réalisés. Pour lui donner une solidité mécanique qui permette toutes les manipulations, un substrat doit être en effet relativement très épais en regard de la fine couche superficielle dans laquelle les composants sont réalisés. Son épaisseur initiale n'est cependant pas compatible avec la réalisation de composants performants à partir de la seconde face. Le premier substrat doit donc être aminci après que le second ait été fixé pour prendre le relais d'un point de vue mécanique. L'amincissement du premier substrat doit alors s'effectuer.

L'état de la technique antérieure qui peut être considéré comme utile pour comprendre la divulgation présente est
YONEHARA T ET AL: "EPITAXIAL LAYER TRANSFER BY BOND AND ETCH BACK OF POROUS SI",APPLIED PHYSICS LETTERS, AIP, AMERICAN INSTITUTE OF PHYSICS, MELVILLE, NY, US LNKD- DOI:10.1063/1.111698, vol. 64, no. 16, 18 avril 1994 (1994-04-18), pages 2108-2110,
US 6 054 363 A (SAKAGUCHI KIYOFUMI [JP] ET AL) 25 avril 2000 (2000-04-25), et
DE 101 00 194 A1 (SAMSUNG ELECTRONICS CO LTD [KR]) 19 juillet 2001 (2001-07-19).

La difficulté majeure pour mettre en oeuvre cette technique dans le cadre d'un processus industriel reproductible tient au fait qu'il faut pouvoir contrôler très précisément l'arrêt de cet amincissement du premier substrat afin de préserver la mince couche superficielle dans laquelle tout ou partie des composants ont déjà été formés à partir de la première face, et sans les endommager.

C'est donc un objet de l'invention que de décrire un procédé propre à obtenir ce résultat.

Alors que les techniques actuelles proposent une réduction d'épaisseur par rupture ou découpe latérale du substrat dans une zone de faiblesse de son épaisseur (qui peut être poreuse), l'invention préconise un amincissement progressif en plusieurs phases évitant la complexité des méthodes précitées.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

L'invention répond à ce besoin en décrivant un procédé de fabrication d'un substrat comprenant une étape d'amincissement de l'épaisseur du substrat. Le procédé de fabrication d'un substrat de l'invention présente comprend une étape d'amincissement de l'épaisseur du substrat, caractérisé par le fait qu'il comporte les étapes suivantes:
- formation d'une zone poreuse dans une couche intérieure du substrat ;
- amincissement progressif de l'épaisseur du substrat en direction de la couche intérieure comprenant la zone poreuse ;
- finalisation de l'amincissement progressif par polissage mécano chimique ;
- arrêt automatique contrôlé du polissage par détection de la zone poreuse au cours du polissage.

Le procédé comprend en outre les étapes et caractéristiques optionnelles suivantes :
- La zone poreuse forme l'intégralité de la couche intérieure.
- La zone poreuse comporte une pluralité de portions poreuses dans la couche intérieure.
- La formation de la zone poreuse est effectuée par porosification d'une épaisseur prédéterminée de la surface d'un substrat primaire suivie par le dépôt ou la croissance d'au moins une couche de recouvrement d'un matériau participant à la réalisation d'un dispositif électronique ou d'un dispositif hybride incluant une partie optique et/ou mécanique.
- La croissance d'au moins une couche de recouvrement est opérée par épitaxie à une température supérieure à 750° C.
- La température est comprise entre 900°C et 1100°C.
- Le dépôt ou la croissance de la au moins une couche de recouvrement est suivi d'un report sur un substrat secondaire fixé sur la dernière des au moins une couche de recouvrement.
- L'étape d'amincissement progressif du substrat est plus rapide que la phase de finalisation de l'amincissement.
- La première phase d'amincissement est effectuée par attaque chimique ou par abrasion mécanique ou par polissage mécano chimique (CMP).
- L'arrêt contrôlé du polissage est opéré immédiatement à la détection de la zone poreuse.
- L'arrêt contrôlé du polissage est opéré après un temps programmé après la détection de la zone poreuse.
- La détection de la zone poreuse est une détection de transition entre une zone non poreuse et la zone poreuse.
- La détection de transition est opérée lors du passage d'une zone non poreuse à la zone poreuse au cours de la finalisation.
- La détection de transition est opérée lors du passage de la zone poreuse à une zone non poreuse au cours de la finalisation.
- La finalisation de l'amincissement progressif par polissage comprend :
   - une étape préliminaire de finalisation,
   - un arrêt contrôlé de l'étape préliminaire de finalisation par détection d'une transition depuis une zone non poreuse du substrat vers la zone poreuse,
   - une étape secondaire de finalisation jusqu'à l'arrêt contrôlé du polissage.
- L'étape secondaire est opérée à vitesse plus lente que l'étape préliminaire.
- On détecte la zone poreuse en exposant la surface en cours de polissage à une source lumineuse et en surveillant l'absorption et/ou la réflexion optique de la surface pour déterminer un début et/ou une fin d'attaque de la couche poreuse.
- La surveillance de l'absorption et/ou de la réflexion optique est améliorée en introduisant dans la solution abrasive un additif destiné à diffuser dans la zone poreuse.
- L'additif est un colorant dont la couleur est complémentaire de la gamme de longueurs d'ondes détectable par le système surveillant l'absorption et/ou la réflexion optique de la surface en cours de polissage.
- On détecte la zone poreuse en mesurant le couple moteur entre la tête et le plateau de polissage pour déterminer les changements de friction indiquant un début et/ou une fin d'attaque de la couche poreuse.
- On détecte la zone poreuse en mesurant l'échauffement du substrat pour déterminer les changements de température indiquant un début et/ou une fin d'attaque de la couche poreuse.

L'invention décrit l'utilisation d'une couche de matériau semi conducteur tel du silicium comportant au moins une zone poreuse comme couche de détection à l'intérieur d'un substrat pour l'arrêt contrôlé d'un polissage.

L'invention décrit en outre un procédé dans lequel la pluralité de portions poreuses dans la couche intérieure est révélée à l'issue de la phase de finalisation contrôlée de l'amincissement pour permettre l'alignement de la partie des dispositifs fabriquée à partir d'une seconde face du substrat sur celle déjà fabriquée à partir d'une première face du substrat.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1 décrit les différentes étapes du procédé selon l'invention.
La FIGURE 2 donne un exemple de moyen connu qui peut être utilisé pour rendre poreux d'une façon contrôlée la couche superficielle du substrat d'origine.
La FIGURE 3 décrit les moyens mis en oeuvre lors de la deuxième étape d'amincissement mécano chimique pour détecter précisément l'émergence de la couche de silicium poreux.
La FIGURE 4 illustre plus particulièrement le mode de détection optique qui sert à détecter l'émergence de la couche de silicium poreux.
La FIGURE 5 décrit une variante de mise en oeuvre de l'invention dans laquelle la couche continue de silicium poreux est remplacée par la création d'une pluralité de motifs faits de silicium poreux.

Les dessins joints sont donnés à titre d'exemples et ne sont pas limitatifs de l'invention.

### DESCRIPTION DÉTAILLÉE DE L'INVENTION

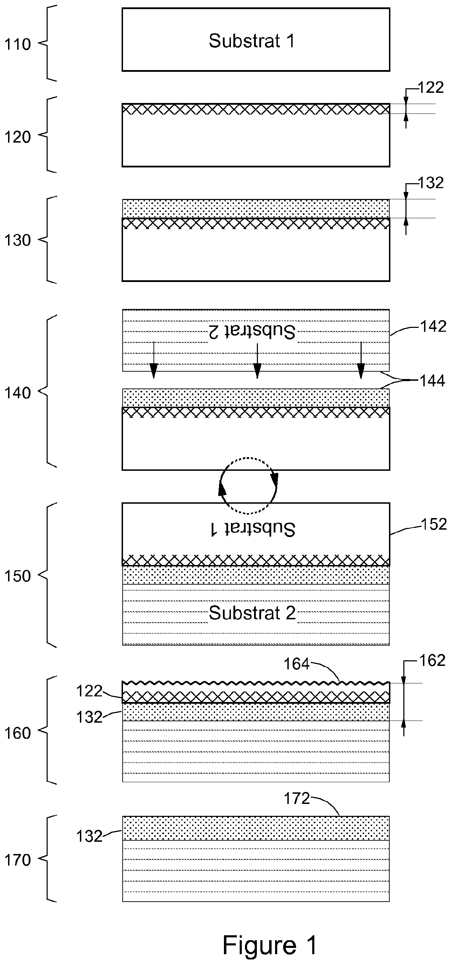

**La** **figure 1** illustre et décrit les différentes étapes du procédé selon l'invention.

Comme déjà indiqué dans le chapitre sur l'état de la technique un matériau de base de toute l'industrie des semi conducteurs et de la micro électronique est communément un substrat monocristallin de silicium 110, souvent dopé de type P, et dont une des faces a déjà reçu généralement un poli optique. Son épaisseur est suffisante pour donner au substrat une solidité et une rigidité mécanique qui permettent toutes les manipulations lors des très nombreuses étapes de fabrication nécessaires à la réalisation de circuits intégrés à sa surface. Substrat qui se présente sous la forme d'une tranche mince dont le diamètre atteint actuellement 30 centimètres et à la surface duquel on réalise simultanément, en fonction de leurs tailles, typiquement, quelques centaines de circuits intégrés simultanément. Si, comme mentionné ci-dessus, le substrat est généralement fait de silicium, l'invention ne fait cependant aucune hypothèse sur la nature de ce dernier hormis le fait qu'il doit pouvoir être porosifié en surface. Notamment, l'utilisation d'autres types de substrats semi-conducteurs tels que le germanium, ou des alliages silicium/germanium (SiGe) peut aussi être considéré comme rapporté, par exemple, dans la publication suivante : « Network dimensionality of porous Si & Ge », S. Bayliss & al., Applied Surface Science, 102, (1996), 390.

Des alliages semi conducteurs binaires du type III-V conviennent également pour l'invention. Il s'agit notamment de l'arséniure de gallium (AsGa), du phosphure d'indium (InP) ou du nitrure de gallium (GaN).

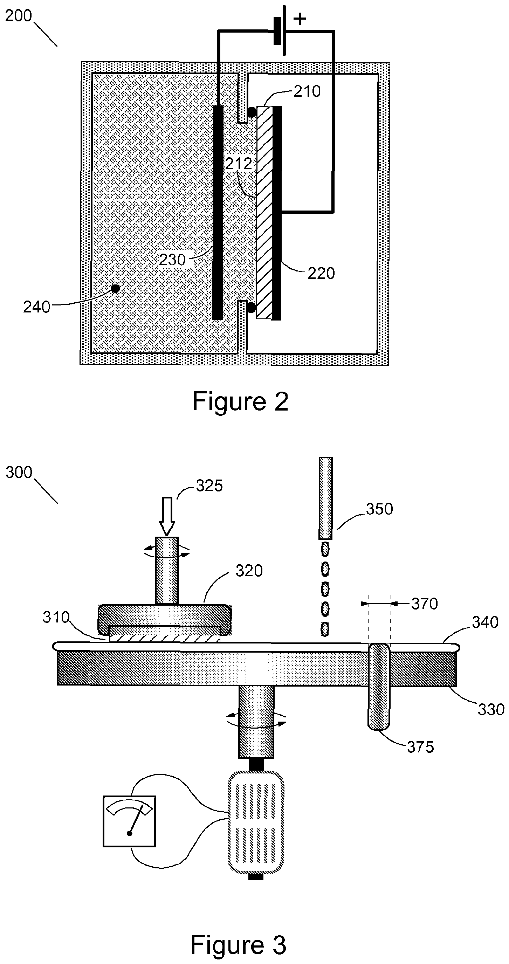

Le procédé selon l'invention demande que dans une première étape 120 une porosification d'une couche superficielle 122 du substrat soit effectuée. D'une façon générale tout matériau cristallin, semi conducteur comme ceux mentionnés ci-dessus, ou non, ou d'un alliage de tels matériaux, pouvant être porosifié est donc susceptible de constituer le substrat 110 à partir duquel le procédé de l'invention sera appliqué. En ce qui concerne le silicium par exemple, la porosification consiste à mettre en oeuvre des techniques connues depuis les années cinquante. Des exemples de mise en oeuvre sont donnés en figure 2. En fonction des dispositifs à produire et des applications considérées du procédé selon l'invention, l'épaisseur de la couche poreuse à réaliser 122 ainsi que ses caractéristiques pourront être très différentes. Notamment, la taille des pores produits pourra varier dans une plage étendue de valeurs allant typiquement de quelques nanomètres (10⁻⁹ mètre) à quelques micromètres (10⁻⁶ mètre) sur une épaisseur comprise, typiquement, entre une centaine de nanomètres et quelques dizaines de micromètres.

On notera par ailleurs que les substrats de silicium sont généralement produits avec une orientation cristalline notée (100). Pour certaines applications il peut être avantageux d'utiliser un substrat en silicium ayant été produit avec une orientation cristalline différente comme par exemple : (111), (110) ou autre. L'obtention de la couche de silicium poreux décrite en figure 2 se fera dans les mêmes conditions que pour un silicium orienté (100). Seule la vitesse porosification pourra être différente.

L'étape suivante 130 consiste à former par-dessus la couche poreuse 122 la ou les couches 132 dans lesquelles les composants seront créés. L'invention ne fait pas d'hypothèse sur le type de composants dont la fabrication est susceptible de bénéficier du procédé décrit. La couche globale 132 pourra elle-même comprendre une pluralité de couches faites de différents matériaux incluant par exemple le silicium sous ses différentes formes : monocristallin, polycristallin, amorphe ; et d'une façon générale tous les matériaux et alliages semi conducteurs mentionnés plus hauts. La couche globale 132 pourra comprendre en outre des oxydes pouvant servir de diélectrique et incluant l'oxyde de silicium ; et d'une façon générale tous les matériaux couramment utilisés par l'industrie de la microélectronique et incluant des dépôts sous vide de couches métalliques d'aluminium, de cuivre, d'or ou d'argent. La formation de la couche globale 132 pourra être obtenue par tous les moyens couramment utilisés pour faire croître ou déposer des matériaux sur un substrat.

Dans l'exemple précédemment mentionné de dispositifs optoélectroniques de type imageur, et d'une façon générale de tout dispositif électronique élaboré devant inclure des éléments actifs de type transistors, la couche 132 sera alors avantageusement formée en faisant croître une couche monocristalline par épitaxie directement sur la couche poreuse 122. La couche porosifiée conservant la structure cristalline du substrat dans lequel elle a été formée tous les types de croissance épitaxiale connus peuvent être envisagés lors de la mise en oeuvre de l'invention.

Le plus couramment une homo-épitaxie de type silicium sur silicium sera pratiquée. Pour tous les autres types de substrats discutés ci-dessus une homo-épitaxie est aussi possible. Il s'agira par exemple d'une épitaxie de SiGe sur une couche ou un substrat de SiGe ou d'une épitaxie d'AsGa sur une couche ou un substrat d'AsGa. Plus généralement, une hétéro-épitaxie d'un matériau X peut être envisagée sur un substrat porosifié Y dans la mesure où la structure cristalline des matériaux X et Y permet que la croissance épitaxiale puisse se faire harmonieusement. Par exemple, sur un substrat de silicium orienté (100), un dépôt de Si(C), solution solide jusqu'à 1% de Carbone, du Ge, du SiGe, de l'AsGa et plus généralement les alliages semi conducteurs de type III-V peuvent être épitaxiés. Sur un substrat de silicium orienté (111) ou (100) un film de SiC, composé intermétallique de silicium et de carbone, peut aussi être épitaxié.

Il est en particulier bien connu de pouvoir épitaxier une couche de silicium monocristalline de bonne qualité sur du silicium poreux. Les conditions d'épitaxie peuvent avoir à différer de celles communément utilisées sur silicium massif si on ne veut pas modifier la structure du silicium poreux qui a été précédemment formé. En particulier, une fois le silicium poreux réalisé, un premier traitement thermique sous vide pourra être appliqué afin de stabiliser la morphologie du silicium poreux avant de réaliser une épitaxie dite à basse température (750°C). Sur ce sujet on pourra par exemple se reporter à la publication suivante : «Epitaxial Growth of High-Quality Silicon Films on Double-Layer Porous Silicon», auteurs : Y.-P.Huang, S.-Y. Zhu, A.-Z. Li, J. Wang, J.-Y. Huang et Z.-Z. Ye, publiée dans Chinese physics letter volume 18 (11), p1507 année 2001.

Dans cet exemple de fabrication de dispositifs optoélectroniques ou dans des dispositifs élaborés comprenant des composants actifs de type transistor toute la partie électronique des dispositifs sera ensuite réalisée d'une façon traditionnelle dans la couche monocristalline épitaxiale 132. Cela comprendra, par exemple, la formation de circuits faits de transistors CMOS (de l'anglais « complementary metal oxide semiconductor ») en faisant appel aux techniques standard mentionnées dans le chapitre sur l'état de la technique : oxydation, photolithographie, diffusion, implantation, dépôt métallique, formation des interconnexions, etc.

Quand la partie des dispositifs qui doit être fabriquée à partir de la première des faces du substrat d'origine est terminée, il faut alors fixer ce dernier, à l'étape suivante 140, sur un second substrat 142 pour réaliser le transfert de la couche 132 et ainsi permettre l'achèvement de la partie des dispositifs qui se fera à partir de la seconde face après amincissement du substrat d'origine. La fixation du second substrat se fait à l'aide de méthodes et de techniques connues permettant d'empiler au niveau tranche des substrats dont les circuits sont partiellement ou entièrement fabriqués. Notamment, on peut faire appel à une technique de collage par adhésion moléculaire oxyde sur oxyde à basse température. Le silicium poreux peut supporter des températures allant jusqu'à 750°C sans entraîner de modifications sensibles de ses caractéristiques physiques. Les collages moléculaires peuvent se faire efficacement jusqu'à ces températures. Ce type de fixation pourra nécessiter le dépôt préalable d'une couche protectrice et une préparation de la surface des substrats 144. L'invention ne fait pas d'hypothèse sur la nature du second substrat 142 dont le rôle est essentiellement de constituer un support mécanique pour les opérations suivantes.

Le résultat est un assemblage 150 au niveau tranche de deux substrats dont le premier 152, celui d'origine, doit être aminci. Par commodité, la représentation de l'assemblage 150 est retournée pour que la face supérieure représente la seconde face du premier substrat, celle à partir de laquelle on va finir de réaliser les dispositifs en cours de fabrication après amincissement.

Dans un mode préféré de mise en oeuvre de l'invention, l'amincissement se fait en au moins deux étapes :
- Au cours d'une première étape 160 on réalise un retrait rapide du silicium qui puisse cependant garantir que la couche de silicium poreux 122, et donc la couche contenant les dispositifs 132, ne soient en aucun cas touchées. Par exemple, la majeure partie du silicium peut être retirée par abrasion mécanique ou par voix chimique ou en combinant les deux moyens. L'attaque chimique peut se faire en utilisant des produits tels que l'hydroxyde de tetramethylammonium (TMAH), l'hydroxyde de potassium ou potasse (KOH), ou encore l'hydroxyde de potassium ou soude (NaOH). Cette première étape préserve donc une partie du silicium d'origine, la couche de silicium poreux et celle contenant les dispositifs en cours de fabrication 162. A l'issue de ce retrait rapide l'état de surface 164 peut alors être relativement mauvais.
- La seconde étape de l'amincissement dite de finalisation consiste à améliorer l'état de surface à l'aide d'un polissage mécano chimique jusqu'à obtenir un nivellement et un état de surface 172 compatible avec les dispositifs à fabriquer. La seconde étape 170 est cruciale en ce que l'amincissement supplémentaire obtenu doit être détecté très précisément pour s'arrêter dès que l'on rencontre le silicium poreux, si cette couche participe à la fabrication du dispositif, ou exactement à l'interface entre silicium poreux et la couche 132 contenant la partie des composants qui ont été réalisés à partir de la première face du substrat d'origine si, comme représenté, elle doit être complètement enlevée. Dans le cas où on ôte totalement la couche poreuse, il peut être avantageux de tirer profit de la détection de deux transitions avec la couche poreuse, à savoir une détection, première chronologiquement, de transition du substrat vers la couche poreuse et une détection, deuxième chronologiquement, de transition en sortie de la couche poreuse. Par exemple, une première phase de finalisation d'amincissement est opérée, avec des paramètres de polissage (tels que vitesse, actifs chimiques) données jusqu'à la première détection, et une deuxième phase de finalisation d'amincissement est opérée, avec d'autres paramètres de polissage (par exemple moins rapides et/ou sans attaque chimique) jusqu'à la deuxième détection. Eventuellement, après la deuxième détection, une étape de finition, telle que par polissage CMP, peut être opérée pour laisser un état de surface de qualité améliorée. C'est le rôle premier de la couche de silicium poreux que de permettre la détection. Comme expliqué en figure 3 différents paramètres lors du polissage mécano chimique peuvent être surveillés permettant une détection précise du début et de la fin de la couche de silicium poreux 122 et donc un arrêt programmé du polissage. Ainsi, la couche de silicium poreux peut être une couche dite « sacrificielle » qui disparaîtra complètement ou, en fonction des dispositifs à produire, participer à la fabrication des dispositifs auquel cas l'arrêt du polissage se fera dès que celle-ci est détectée ou après un temps supplémentaire programmé pour n'en laisser qu'une partie.

La **figure 2** donne un exemple de moyen connu qui peut être utilisé pour rendre poreux d'une façon contrôlée la couche superficielle 122 du substrat d'origine.

Depuis les années cinquante on sait obtenir du silicium poreux par voie électrochimique à partir de silicium monocristallin. La porosification est obtenue par dissolution anodique en présence d'acide fluorhydrique (HF). Un appareillage 200 du type de celui représenté en figure 2 peut être utilisé pour traiter chaque plaque de silicium constituant le premier substrat du procédé décrit en figure 1. La face 212 du substrat 210 qui doit être porosifiée est mise en contact avec un milieu aqueux d'acide fluorhydrique 240 dont la concentration peut typiquement varier de 1% à 50% et avantageusement entre 5% et 35%. On impose une différence de potentiel ou un courant continue entre une cathode 230, immergée dans la solution aqueuse d'acide fluorhydrique, et une anode 220 qui est en contact électrique avec l'autre face du substrat à porosifier. La concentration en acide fluorhydrique du milieu aqueux, la valeur du courant que l'on impose et le temps d'anodisation sont, entre autres, des paramètres qui permettent de contrôler les caractéristiques de la couche poreuse que l'on désire obtenir. Des appareillages plus sophistiqués que celui représenté permettent aussi d'illuminer le milieu aqueux ajoutant un moyen de contrôle supplémentaire des caractéristiques de la couche poreuse. L'utilisation d'une illumination du milieu aqueux dépend essentiellement du type de semi conducteur poreux recherché et de la résistivité de celui-ci.

Toutes les conditions d'élaboration de la couche poreuse, c'est-à-dire : la solution électrolytique employée (sa concentration en acide fluorhydrique) ; le courant circulant entre anode et cathode ; la tension appliquée ; les conditions d'illumination ainsi que la nature même du substrat (type P, N, son niveau de dopage) interviennent pour permettre de contrôler, en fonction des applications, l'obtention de pores de tailles pouvant varier dans une large plage de valeurs allant de quelques nanomètres à quelques micromètres.

Par exemple, pour un substrat de type P⁺ dont la résistivité est de l'ordre de quelques dizaines de milliOhms/cm, la porosification peut être obtenue directement, sans nécessiter d'autre traitement, par anodisation du substrat dans le milieu acide. La densité de courant utilisée pour porosifier un tel matériau pourra varier de quelques milliAmpère/cm² à plusieurs Ampères/cm². D'une façon générale, plus la concentration en acide est élevée, plus les densités de courant de travail peuvent être sans inconvénient importantes. Il est ainsi possible de faire varier la grosseur des pores dans la plage de valeurs indiquée ci-dessus ainsi que le taux de porosité. Ce dernier pouvant aller typiquement de 10 à 90%.

Dans le cas d'utilisation d'un substrat beaucoup plus résistant, par exemple un substrat de type P ayant une résistivité de plusieurs Ohms/cm, un traitement de la face arrière devra être envisagé pour diminuer la résistance électrique. Cela se fera préalablement à l'étape de porosification, par exemple, par implantation ionique sur la face arrière du premier substrat d'un dopant de type P.

Les caractéristiques morphologiques du silicium poreux obtenu (tailles de pores, taux de porosité et épaisseur) en fonction des conditions mises en oeuvre pour son élaboration et mentionnées ci-dessus (concentration du milieu acide, densité de courant, illumination, type de substrat) sont décrites dans de nombreuses publications scientifiques et ont fait l'objet d'ouvrages dédiés. Ils permettent à l'homme du métier de déterminer rapidement les conditions à mettre en oeuvre pour obtenir, sur un substrat d'un type donné, une couche de silicium poreux de caractéristiques appropriées au type de dispositif à produire.

La **figure 3** décrit les moyens mis en oeuvre lors de la deuxième étape d'amincissement mécano chimique pour détecter précisément l'émergence de la couche de silicium poreux.

Le polissage mécano chimique, souvent désigné par l'acronyme CMP (de l'anglais « Chemical Mechanical Polishing »), est une technique largement utilisée dans le domaine de la microélectronique pour polir les substrats et pour aplanir des motifs obtenus après dépôt de couches minces sur un substrat. La surface est polie par frottement sur un tissu appelé « pad » fait de polyuréthane poreux viscoélastique, dont les propriétés (incluant : dureté, compressibilité, forme et dimension des pores et des motifs) sont adaptées à la nature du matériau à polir et à la finesse du polissage à obtenir. Le matériau à la surface du substrat est enlevé par la combinaison de l'action mécanique résultant du frottement sur le pad et d'une réaction chimique avec une solution aqueuse contenant des particules nanométriques en suspension appelée «slurry ». Selon les applications considérées la solution chimique est différente, elle peut être acide ou basique et comprendre des particules abrasives de types et de tailles variés.

Pour procéder au polissage mécano chimique la tranche de silicium est placée dans un appareillage 300 du type de celui représenté en figure 3. Elle est fixée sur la tête rotative de polissage 320, la face à polir étant orientée vers le bas. Le tout prend appui sur le plateau rotatif 330 sur lequel est fixé le tissu ou pad de polissage 340 décrit ci-dessus. La tête de polissage exerce une pression 325 sur la tranche de silicium. La force d'appui et la vitesse relative entre la tête et le plateau permettent de contrôler la vitesse et l'uniformité du retrait du matériau. La solution abrasive, le slurry, est dispensée en continue sur le plateau avec un débit contrôlé. Au cours du polissage la solution abrasive est continuellement renouvelée alors que le matériau poli en suspension dans celle-ci est évacué vers l'extérieur du plateau par effet centrifuge.

Dans le cadre général de l'utilisation de ce type de polisseuse les conditions de polissage ont été étudiées avec soin par la communauté scientifique travaillant dans ce domaine. Notamment, la vitesse d'enlèvement du matériau a été modélisée et peut être estimée avec une relative bonne précision en fonction de tous les paramètres qui la contrôlent, notamment : la pression d'appui, la vitesse relative orbitale de la tranche de silicium, le débit de la solution aqueuse contenant les particules abrasives et sa composition, la température ambiante. On pourra par exemple se reporter à un article par D. Peyrade et al., publié dans « Microelectronic Engineering 83, p. 1521 » en 2006.

Toutefois, l'invention ne repose en rien sur une détermination, aussi précise puisse-t-elle être, de la vitesse d'enlèvement pour arrêter le polissage. Il se fait automatiquement sur la base de la détection de l'émergence de la couche de silicium poreux réalisé à la surface du premier substrat comme décrit en figure 2. Arrêt qui peut se faire optionnellement soit en début de détection, soit en fin de détection, ou dans l'intervalle, suivant que tout ou partie de la couche de silicium poreux doit être enlevée en fonction du type de dispositif à produire.

D'une façon générale, dans le cadre d'un polissage mécano chimique, tout paramètre physique mesurable qui admet une variation notable lors d'une transition entre deux couches peut être utilisé comme moyen de détection. L'invention considère plus particulièrement les moyens suivants, utilisés seuls ou en combinaison, pour détecter l'émergence de la couche de silicium poreux au cours de l'opération de polissage mécano chimique.
- Le frottement de la tranche 310 sur le pad 340 provoque un échauffement qui est différent entre le silicium dense du substrat et celui de la couche poreuse. La mesure de la température peut être surveillée pour détecter les changements de celle-ci et donc les transitions entre couches de natures différentes.
- Le polissage doit se faire avec une vitesse constante de rotation du plateau 330. Afin de garder cette vitesse constante, un asservissement réajuste l'alimentation en courant du moteur 360. Plus la friction est importante, plus le couple moteur doit être fort et plus le courant d'alimentation de ce dernier est élevé. La lecture du courant d'alimentation du moteur 365 permet de détecter la transition entre deux couches d'autant plus facilement qu'elles ont une viscosité fort différente. Ce qui est le cas entre le silicium poreux de surface et le silicium dense du substrat.
- Les propriétés optiques de la surface varient beaucoup en cours de polissage en fonction des matériaux rencontrés : silicium dense et poreux dans le cas de l'invention. En ménageant une fenêtre d'observation 370 à travers le plateau et le pad il est possible d'insérer un système de détection optique 375 qui pourra mesurer certaines de ces propriétés, par exemple l'absorption et la réflexion de lumière émise par le système de détection à chaque fois que la tranche en cours de polissage se trouve au dessus de la fenêtre d'observation. En fonction des applications considérées la gamme de longueur d'ondes utilisée peut varier entre celle des rayons dits X (une dizaine de nanomètres) à celle de l'infrarouge (au-delà de 800 nanomètres). Comme avec la température de la tranche et le courant d'alimentation du moteur ces paramètres optiques peuvent être surveillés pour déterminer avec une grande précision les transitions entre couches.

À ce stade de la description du procédé de l'invention il convient de remarquer que, quel que soit le ou les moyens mis en oeuvre pour détecter l'émergence de la couche poreuse, l'intensité des signaux détectés (température et/ou frottement et/ou absorption optique) dépendra aussi pour beaucoup des caractéristiques physiques de la couche poreuse 122 qui aura été formée sur le substrat 110. A cet effet, dans le cas où une couche épitaxiale monocristalline doit être formée sur la couche poreuse, l'invention fait état en figure 1 d'une méthode de formation de cette couche à basse température (750°C) afin que les caractéristiques physiques initiales de la couche poreuse sous jacente n'en soient pas sensiblement affectées et restent optimales pour sa détection. Les moyens de détection décrits ci-dessus, utilisés seuls ou en combinaison, sont cependant suffisamment sensibles pour s'accommoder d'une modification des caractéristiques physiques de la couche poreuse qui ferait que la formation de la couche monocristalline provoquerait un affaiblissement du ou des signaux détectés. En particulier il est tout à fait possible de pratiquer une croissance épitaxiale de la couche 132 à des températures plus élevées que celle mentionnée ci-dessus et notamment entre 900°C et 1100°C. En particulier, sur du silicium massif, l'épitaxie peut se pratiquer à une température de 950°C. On a pu mettre en évidence que si cela affaiblissait les signaux de détection de la zone poreuse en raison des modifications de la couche poreuse qui résultent de l'emploi d'un traitement thermique à des températures supérieures à 750°C ceux-ci restent cependant suffisamment discernables pour contrôler précisément l'arrêt du polissage mécanique ou mécano chimique.

On notera que l'invention est sur ce point très avantageuse en tirant profit d'une détection de transition de couches pour arrêter l'amincissement. Des techniques actuelles jouant sur la sélectivité d'une attaque chimique entre couche poreuse et non poreuse ne pourraient être mises en oeuvre aux températures élevées, par chute de la sélectivité.

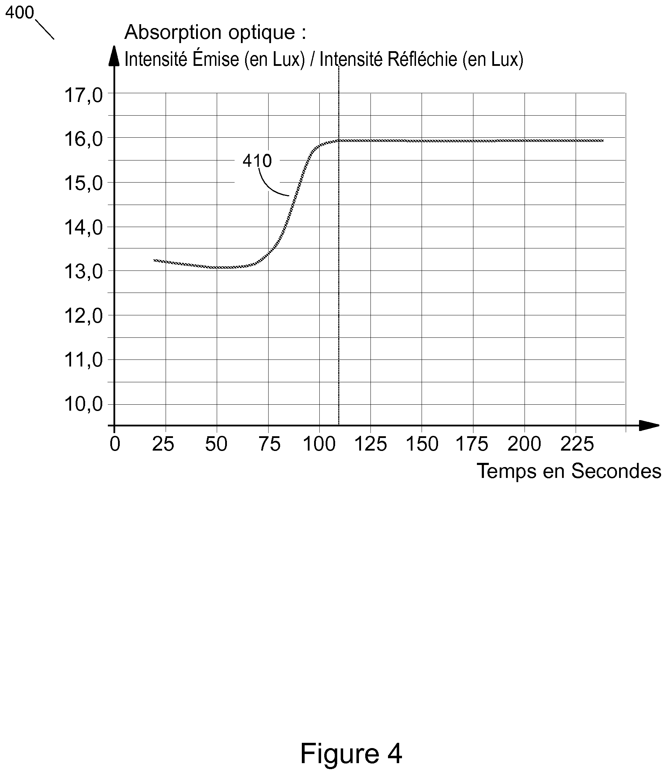

La **figure 4** illustre plus particulièrement le mode de détection optique décrit ci-dessus.

L'absorption optique entre une couche de silicium poreux et le silicium dense du substrat est très différente. Cette différence peut être observée par un système de détection optique approprié pouvant travailler dans une large gamme de longueur d'onde comprise, typiquement, entre 800 nm jusqu'au micromètre et au-delà, c'est-à-dire dans le rouge et l'infra rouge. La différence d'absorption optique est observable pour la large gamme de silicium poreux considérée précédemment et dont les caractéristiques (taux de porosité, taille des pores) peuvent être très différentes en fonction du type de dispositifs à produire.

Une amélioration optionnelle de la détection peut être mis en oeuvre qui consiste à ajouter un produit spécifique dans la solution abrasive (slurry), notamment un « colorant », afin de faciliter la détection optique du type de couche en cours de polissage. Celui-ci, en diffusant dans la couche de silicium poreux, en modifiera les propriétés optiques et améliorera la détection des transitions.

S'il s'avère nécessaire d'ajouter un colorant (ou pigment), et plus généralement d'introduire un additif dans la solution de polissage mécano chimique ou slurry, l'additif devra nécessairement être choisi en tenant compte non seulement de sa solubilité dans le slurry mais aussi en fonction du système de détection optique utilisé et des propriétés d'absorption ou de réflexion du mélange slurry/additif pour la gamme de longueur d'ondes de ce dernier. L'additif ne devra pas non plus modifier la fonction première de la solution de polissage et dégrader l'un des matériaux en présence. De façon générale, les solutions chimiques de polissage sont le plus souvent de nature aqueuse, de type acide (pH ≤ 7) ou alcaline (pH ≥ 7). Un certain nombre de colorants (ou pigments) sont effectivement solubles dans l'eau. Des sociétés sont spécialisées dans la fabrication de ce type de composés et proposent des colorants dans toute la gamme du spectre visible des couleurs.

De nombreuses publications techniques sont par ailleurs disponibles qui permettent à l'homme du métier de choisir judicieusement l'additif en fonction des caractéristiques du système optique utilisé. Notamment, en considérant la propriété physico-chimique suivante : une solution colorée absorbe la lumière dans la gamme spectrale complémentaire de celle qu'elle émet. En conséquence, si par exemple la longueur d'onde du détecteur est dans le rouge ou proche infra rouge (longueurs d'ondes de l'ordre de 800 à 1000 nm), un colorant vert (longueur d'onde de l'ordre de 550 nm) ou bleu (longueur d'onde de l'ordre de 400nm) sera le plus approprié.

La courbe 400 donne un exemple de différence d'absorption optique qui peut être observée entre le silicium dense du substrat et celui de la couche poreuse et qui permet de détecter très précisément la transition 410 entre les deux types de matériau. L'absorption optique figurant en ordonnée est le rapport entre l'intensité de la lumière émise sur l'intensité de celle qui est réfléchie, mesurées ici en Lux.

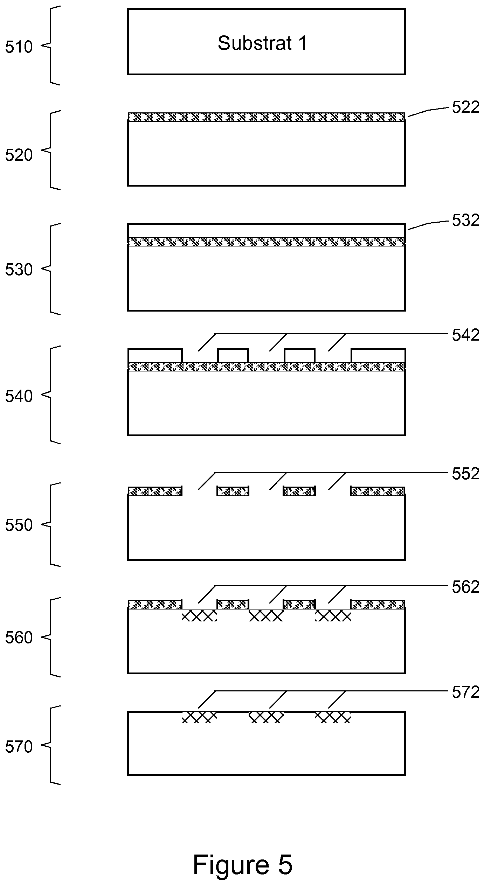

La **figure 5** décrit une variante de mise en oeuvre de l'invention dans laquelle la couche de silicium poreux que l'on réalise lors de la première étape 120 du procédé décrit en figure 1 sur toute la surface du premier substrat est remplacée par la création d'une pluralité de motifs faits de silicium poreux.

La création des motifs se fait en ajoutant préalablement à l'étape de porosification par dissolution anodique en présence d'acide fluorhydrique décrite en figure 2 les étapes suivantes qui permettront de délimiter à la surface du premier substrat, en place de la couche continue, toutes les zones de silicium poreux que l'on désire créer.

Comme dans le procédé décrit en figure 1 le point de départ 510 est un substrat de silicium monocristallin.

A l'étape suivante 520, sur ce substrat, on va venir déposer une couche d'un matériau 522 qui va servir de protection lors de l'opération de porosification pour les surfaces comprises entre toutes les zones à porosifier. Le matériau déposé devra être résistant à la dissolution anodique. C'est par exemple le cas du nitrure de silicium (Si₃N₄). Le dépôt peut être réalisé par différentes méthodes couramment employées en microélectronique, par exemple à relativement basse température par voie gazeuse en formant un plasma dans une enceinte confinée.

Les opérations suivantes sont des opérations classiques de photolithographie qui permettent de définir les motifs des zones dans lesquelles la porosification du silicium devra être opérée. Ces opérations comprennent le dépôt 530 d'une couche de résine 532. Dépôt qui est suivi de l'opération de photolithographie 540 comprenant la dissolution de la résine à l'endroit des motifs à graver 542 après que celle-ci a été sélectivement insolée à travers un masque par exemple. La gravure 550 de la couche de nitrure de silicium est ensuite effectuée aux endroits définis par les motifs 552 après quoi toute la résine est enlevée.

A ce stade 560, la porosification du silicium est effectuée dans les mêmes conditions que décrites à l'étape 120 de la figure 1 et avec les moyens décrits en figure 2. La différence étant dans ce cas que seules les zones non protégées par le nitrure de silicium 562 sont porosifiées en surface. L'étape suivante 570 consiste à enlever le nitrure de silicium restant en ne laissant que les motifs de silicium poreux 572 à la surface du premier substrat.

Hormis le fait que des motifs de silicium poreux sont présents dans ce cas à la surface du premier substrat, en lieu et place d'une couche continue de silicium poreux, le résultat est équivalent a ce qui est obtenu à l'étape 120 de la figure 1. Toutes les autres étapes (130 à 170) peuvent alors s'appliquer d'une façon identique pour produire des dispositifs à partir des deux faces d'un même substrat comme décrit en figure 1. L'étape critique d'arrêt automatique du polissage lors de la seconde étape d'amincissement du premier substrat 170 se fera d'une façon similaire dans la mesure où la surface couverte par les motifs de silicium poreux est importante.

Cette variante du procédé selon l'invention étend significativement les options de réalisation qu'il est possible de considérer pour la fabrication de dispositifs à partir des deux faces d'un même substrat. En particulier la présence de motifs de silicium poreux laissés après la seconde opération d'amincissement peut être révélée et servir au positionnement des composants à réaliser sur la seconde face du substrat par rapport à ceux déjà créés sur la première des faces.

Ainsi, l'invention décrit l'utilisation d'une couche de silicium comportant au moins une zone poreuse comme couche de détection à l'intérieur d'un substrat pour l'arrêt contrôlé d'un polissage.

## Revendications

1. Procédé de fabrication d'un substrat comprenant une étape d'amincissement de l'épaisseur du substrat, **caractérisé par le fait qu'**il comporte les étapes suivantes :
- formation d'une zone poreuse dans une couche intérieure du substrat ;
- amincissement progressif de l'épaisseur du substrat en direction de la couche intérieure comprenant la zone poreuse ;
- finalisation de l'amincissement progressif par polissage mécano chimique ;
- arrêt automatique contrôlé du polissage par détection de la zone poreuse au cours du polissage.

2. Procédé selon la revendication 1 comprenant au cours de la finalisation de l'amincissement progressif et durant l'opération du polissage mécano chimique, la surveillance d'au moins un paramètre physique mesurable qui admet une variation notable lors d'une transition entre deux couches.

3. Procédé selon l'une des revendications précédentes dans lequel la zone poreuse forme l'intégralité de la couche intérieure.

4. Procédé selon l'une des revendications 1 ou 2, dans lequel la zone poreuse comporte une pluralité de portions poreuses dans la couche intérieure.

5. Procédé selon la revendication 4 dans lequel la pluralité de portions poreuses dans la couche intérieure est révélée à l'issue de la phase de finalisation de l'amincissement pour permettre l'alignement de la partie des dispositifs fabriquée à partir d'une seconde face du substrat sur celle déjà fabriquée à partir d'une première face du substrat.

6. Procédé selon l'une des revendications précédentes dans lequel la formation de la zone poreuse est effectuée par porosification d'une épaisseur prédéterminée de la surface d'un substrat primaire suivie par le dépôt ou la croissance d'au moins une couche de recouvrement d'un matériau participant à la réalisation d'un dispositif électronique ou d'un dispositif hybride incluant une partie optique et/ou mécanique.

7. Procédé selon la revendication précédente dans lequel la croissance d'au moins une couche de recouvrement est opérée par épitaxie à une température supérieure à 750° C.

8. Procédé selon la revendication précédente dans lequel la température est comprise entre 900°C et 1100°C.

9. Procédé selon l'une des trois revendications précédentes dans lequel le dépôt ou la croissance de la au moins une couche de recouvrement est suivi d'un report sur un substrat secondaire fixé sur la dernière des au moins une couche de recouvrement.

10. Procédé selon l'une des revendications précédentes dans lequel l'étape d'amincissement progressif du substrat est plus rapide que la phase de finalisation de l'amincissement.

11. Procédé selon la revendication précédente dans lequel la première phase d'amincissement est effectuée par attaque chimique, par abrasion mécanique ou par polissage mécano chimique (CMP).

12. Procédé selon l'une des revendications précédentes dans lequel l'arrêt contrôlé du polissage est opéré immédiatement à la détection de la zone poreuse.

13. Procédé selon l'une des revendications 1 à 11 dans lequel l'arrêt contrôlé du polissage est opéré après un temps programmé après la détection de la zone poreuse.

14. Procédé selon l'une des revendications précédentes dans lequel la détection de la zone poreuse est une détection de transition entre une zone non poreuse et la zone poreuse.

15. Procédé selon la revendication précédente dans lequel la détection de transition est opérée lors du passage d'une zone non poreuse à la zone poreuse au cours de la finalisation.

16. Procédé selon la revendication 14 dans lequel la détection de transition est opérée lors du passage de la zone poreuse à une zone non poreuse au cours de la finalisation.

17. Procédé selon la revendication 15 dans lequel la finalisation de l'amincissement progressif par polissage comprend :
- une étape préliminaire de finalisation,
- un arrêt contrôlé de l'étape préliminaire de finalisation par détection d'une transition depuis une zone non poreuse du substrat vers la zone poreuse,
- une étape secondaire de finalisation jusqu'à l'arrêt contrôlé du polissage.

18. Procédé selon la revendication précédente dans lequel l'étape secondaire est opérée à vitesse plus lente que l'étape préliminaire.

19. Procédé selon l'une des revendications précédentes, dans lequel on détecte la zone poreuse en exposant la surface en cours de polissage à une source lumineuse et en surveillant l'absorption et/ou la réflexion optique de la surface pour déterminer un début et/ou une fin d'attaque de la couche poreuse.

20. Procédé selon la revendication précédente dans lequel la surveillance de l'absorption et/ou de la réflexion optique est améliorée en introduisant dans la solution abrasive un additif destiné à diffuser dans la zone poreuse.

21. Procédé selon la revendication précédente dans lequel l'additif est un colorant dont la couleur est complémentaire de la gamme de longueurs d'ondes détectable par le système surveillant l'absorption et/ou la réflexion optique de la surface en cours de polissage.

22. Procédé selon l'une des revendications 1 à 18 dans lequel on détecte la zone poreuse en mesurant le couple moteur entre la tête et le plateau de polissage pour déterminer les changements de friction indiquant un début et/ou une fin d'attaque de la couche poreuse.

23. Procédé selon l'une des revendications 1 à 18 dans lequel on détecte la zone poreuse en mesurant l'échauffement du substrat pour déterminer les changements de température indiquant un début et/ou une fin d'attaque de la couche poreuse.

## Patentansprüche

1. Verfahren zum Herstellen eines Substrats, umfassend einen Schritt des Verjüngens der Substratdicke, **dadurch gekennzeichnet, dass** es nachstehende Schritte umfasst:
- Ausbilden eines porösen Bereichs in einer Innenschicht des Substrats;
- progressives Verjüngen der Substratdicke in Richtung der den porösen Bereich enthaltenden Innenschicht;
- Endbearbeitung der progressiven Verjüngung durch mechanisch-chemisches Polieren;
- automatisches, gesteuertes Anhalten des Poliervorgangs durch Erfassen des porösen Bereichs im Laufe des Polierens.

2. Verfahren nach Anspruch 1, umfassend während der Endbearbeitung der progressiven Verjüngung und im Laufe des mechanisch-chemischen Poliervorgangs das Überwachen von zumindest einem messbaren physikalischen Parameter, der eine merkliche Änderung beim Übergang zwischen zwei Schichten zulässt.

3. Verfahren nach einem der vorangehenden Ansprüche, wobei der poröse Bereich die gesamte Innenschicht bildet.

4. Verfahren nach einem der Ansprüche 1 oder 2, wobei der poröse Bereich eine Mehrzahl von porösen Abschnitten in der Innenschicht enthält.

5. Verfahren nach Anspruch 4, wobei die Mehrzahl von porösen Abschnitten in der Innenschicht am Ende der Endbearbeitungsphase der Verjüngung freigelegt wird, um das Ausrichten desjenigen Teils der Vorrichtungen, der ausgehend von einer zweiten Seite des Substrats hergestellt wird, in Bezug auf denjenigen zu ermöglichen, der bereits ausgehend von einer ersten Seite des Substrats hergestellt wurde.

6. Verfahren nach einem der vorangehenden Ansprüche, wobei das Ausbilden des porösen Bereichs dadurch erfolgt, dass eine vorbestimmte Dicke der Oberfläche eines Primärsubstrats porös gemacht wird, gefolgt von dem Abscheiden bzw. Aufwachsen von zumindest einer Deckschicht eines Materials, das beim Herstellen einer elektronischen Vorrichtung bzw. einer hybriden Vorrichtung mit einem optischen und/oder mechanischen Teil mitwirkt.

7. Verfahren nach dem vorangehenden Anspruch, wobei das Aufwachsen zumindest einer Deckschicht durch Epitaxie bei einer Temperatur von über 750°C erfolgt.

8. Verfahren nach dem vorangehenden Anspruch, wobei die Temperatur zwischen 900°C und 1100°C beträgt.

9. Verfahren nach einem der vorangehenden drei Ansprüche, wobei dem Abscheiden bzw. Aufwachsen der zumindest einen Deckschicht ein Übertragen auf ein Sekundärsubstrat folgt, das an die letzte der zumindest einen Deckschicht fixiert ist.

10. Verfahren nach einem der vorangehenden Ansprüche, wobei der Schritt des progressiven Verjüngens des Substrats schneller erfolgt als die Endbearbeitungsphase der Verjüngung.

11. Verfahren nach dem vorangehenden Anspruch, wobei die erste Phase des Verjüngens durch chemisches Ätzen, mechanischen Abrieb oder mechanisch-chemisches Polieren (CMP) erfolgt.

12. Verfahren nach einem der vorangehenden Ansprüche, wobei das gesteuerte Anhalten des Poliervorgangs unmittelbar bei Erfassen des porösen Bereichs erfolgt.

13. Verfahren nach einem der Ansprüche 1 bis 11, wobei das gesteuerte Anhalten des Poliervorgangs nach einer nach Erfassen des porösen Bereichs programmierten Zeit erfolgt.

14. Verfahren nach einem der vorangehenden Ansprüche, wobei das Erfassen des porösen Bereichs ein Erfassen des Übergangs zwischen einem nicht porösen Bereich und einem porösen Bereich ist.

15. Verfahren nach dem vorangehenden Anspruch, wobei das Erfassen des Übergangs beim Passieren von einem nicht porösen Bereich zum porösen Bereich im Laufe der Endbearbeitung erfolgt.

16. Verfahren nach Anspruch 14, wobei das Erfassen des Übergangs beim Passieren von dem porösen Bereich zu einem nicht porösen Bereich im Laufe der Endbearbeitung erfolgt.

17. Verfahren nach Anspruch 15, wobei die Endbearbeitung der progressiven Verjüngung durch Polieren umfasst:
- einen vorbereitenden Schritt der Endbearbeitung,
- ein gesteuertes Anhalten des vorbereitenden Schritts der Endbearbeitung durch Erfassen eines Übergangs von einem nicht porösen Bereich des Substrats zum porösen Bereich,
- einen zweiten Schritt der Endbearbeitung bis zum gesteuerten Anhalten des Poliervorgangs.

18. Verfahren nach dem vorangehenden Anspruch, wobei der zweite Schritt mit einer langsameren Geschwindigkeit als der vorbereitende Schritt erfolgt.

19. Verfahren nach einem der vorangehenden Ansprüche, wobei der poröse Bereich erfasst wird, indem die Oberfläche beim Polieren einer Lichtquelle ausgesetzt wird und die Absorption und/oder die optische Reflexion der Oberfläche überwacht wird, um einen Anfang und/oder ein Ende des Angreifens des porösen Bereichs zu bestimmen.

20. Verfahren nach dem vorangehenden Anspruch, wobei das Überwachen der Absorption und/oder der optischen Reflexion verbessert wird, indem in die Abrieblösung ein Zusatzstoff eingebracht wird, der dazu bestimmt ist, in den porösen Bereich zu diffundieren.

21. Verfahren nach dem vorangehenden Anspruch, wobei der Zusatzstoff ein Farbstoff ist, dessen Farbe zu dem Wellenlängenbereich komplementär ist, der durch das System erfasst werden kann, das die Absorption und/oder die optische Reflexion der Oberfläche beim Polieren überwacht.

22. Verfahren nach einem der Ansprüche 1 bis 18, wobei der poröse Bereich erfasst wird, indem das Antriebsmoment zwischen dem Kopf und der Polierplatte gemessen wird, um die Reibungsänderungen zu ermitteln, die einen Anfang und/oder ein Ende des Angreifens der porösen Schicht angeben.

23. Verfahren nach einem der Ansprüche 1 bis 18, wobei der poröse Bereich erfasst wird, indem die Erwärmung des Substrats gemessen wird, um die Temperaturänderungen zu ermitteln, die einen Anfang und/oder ein Ende des Angreifens der porösen Schicht angeben.

## Claims

1. A method for producing a substrate including a step of thinning the thickness of the substrate, said method including the following steps:
- formation of a porous zone in an inner layer of the substrate;
- progressive thinning of the thickness of the substrate towards the inner layer including the porous zone;
- completion of the progressive thinning by mechano-chemical polishing;
- automatic controlled stoppage of the polishing by detection of the porous zone during the polishing.

2. A method according to claim 1, comprising, during the completion of the progressive thinning and during the mechano-chemical polishing, watching at least one measurable physical parameter which presents a noticeable variation upon a transition between two layers.

3. A method according to one of the preceding claims, wherein the porous zone forms the whole inner layer.

4. A method according to one of claims 1 or 2, wherein the porous zone includes a plurality of porous portions in the inner layer.

5. A method according to claim 4, wherein the plurality of porous portions in the inner layer is revealed at the end of the thinning completion phase so as to enable the alignment of the part of the devices produced from a second face of the substrate with the one already produced from a first face of the substrate.

6. A method according to one of the preceding claims, wherein the formation of the porous zone is executed by the porosification of a predetermined thickness of the surface of a primary substrate followed by the deposition or the growth of at least one covering layer made of a material participating in the production of an electronic device or an hybrid device including an optical and/or a mechanical part.

7. A method according to the preceding claim, wherein the growth of at least one covering layer is executed by epitaxy at a temperature above 750°C.

8. A method according to the preceding claim, wherein the temperature is between 900°C and 1,100°C.

9. A method according to one of the three preceding claims, wherein the deposition or the growth of the at least one covering layer is followed by the report onto a secondary substrate fixed on the last one of the at least one covering layer.

10. A method according to one of the preceding claims, wherein the step of progressive thinning of the substrate is quicker than the thinning completion phase.

11. A method according to the preceding claim, wherein the first thinning phase is performed by a chemical attack, by a mechanical abrasion or by a mechano-chemical polishing (CMP).

12. A method according to one of the preceding claim, wherein the controlled stoppage of the polishing is performed immediately upon the detection of the porous zone.

13. A method according to one of claims 1 to 11, wherein the controlled stoppage of the polishing is performed after a programmed time after the detection of the porous zone.

14. A method according to one of the preceding claims, wherein the detection of the porous zone is a detection of the transition between a non porous zone and the porous zone.

15. A method according to the preceding claim, wherein the detection of the transition is performed upon the passage from a non porous zone to the porous zone during the completion.

16. A method according to claim 14, wherein the detection of the transition is performed upon the passage from the porous zone to a non porous zone during the completion.

17. A method according to the claim 15, wherein the completion of the progressive thinning by polishing includes:
- a preliminary step of completion,
- a controlled stoppage of the preliminary step of completion by detection of a transition from a non porous zone of the substrate to the porous zone,
- a secondary step of completion until the controlled stoppage of the polishing.

18. A method according to the preceding claim, wherein the secondary step is carried out at a lower speed than the preliminary step.

19. A method according to one of the preceding claims, wherein the porous zone is detected by exposing the surface being polished to a light source and by monitoring the absorption and/or the optical reflectivity of the surface so as to determine the beginning and/or the end of an attack of the porous layer.

20. A method according to the preceding claim, wherein the monitoring of the absorption and/or of the optical reflectivity is enhanced by introducing into the abrasive solution an additive intended to scatter into the porous zone.

21. A method according to the preceding claim, wherein the additive is a colouring agent, the colour of which is complementary to the range of wavelengths which can be detected by the system monitoring the absorption and/or optical reflectivity of the surface being polished.

22. A method according to one of claims 1 to 18, wherein the porous zone is detected by measuring the driving torque between the polishing head and plate, so as to determine the changes in friction showing the beginning and/or the end of an attack of the porous layer.

23. A method according to one of claims 1 to 18, wherein the porous zone is detected by measuring the heating of the substrate so as to determine the changes in temperature showing the beginning and/or the end of an attack of the porous layer.
